# EUROPEAN PATENT APPLICATION

(11) **EP 4 535 419 A1**
(43) Date of publication of application: **09.04.2025**
(21) Application number: 24204923.7
(22) Date of filing: 07.10.2024
(51) Int. Cl.: H01L 23/373, C04B 37/02

(54) **A SUBSTRATE FOR POWER SEMICONDUCTOR PACKAGING AND A PACKAGE CONTAINING SUCH SUBSTRATE**

(30) Priority: 07.10.2023 CN 202311287735
(71) Applicant: Nexperia B.V., 6534 AB Nijmegen (NL); Nexperia Technology (Shanghai) Ltd., Shanghai 200025 (CN)
(72) Inventor: Gong, Wei, Manchester (GB); Wu, Xiangshui, Shanghai (CN); Cui, Song, Shanghai (CN); Zhu, Chunlin, Shanghai (CN); Jiang, Ke, Shanghai (CN)
(74) Representative: Pjanovic, Ilija

(57) **Abstract**

The present invention discloses a substrate for power semiconductor packaging and a package containing such substrate. The substrate comprises: a first metal layer for contacting with a semiconductor device, a second metal layer for contacting with a heat dissipation device, an electrical insulation layer disposed between the first metal layer and the second metal layer, and a first graphene bulk layer disposed between the electrical insulation layer and the first metal layer, a first surface of the first graphene bulk layer is in contact with a first surface of the first metal layer, and a second surface of the first graphene bulk layer opposite to the first surface is in contact with a first surface of the electrical insulation layer. Compared to the conventional substrate, the novel substrate of the present invention exhibits much lower thermal resistance, higher mechanical strength, and enhanced corrosion resistance.

## Description

### TECHNICAL FIELD

The present invention relates to a semiconductor substrate, in particular a substrate for power semiconductor packaging and a package containing such substrate.

### BACKGROUND OF THE INVENTION

Under high voltage, large current, and high switching frequency operating conditions, power semiconductor devices generate significant switching losses and conduction losses, resulting in the generation of a substantial amount of heat. The high temperature produced by this heat, along with the temperature cycling caused by the transitions between high and low temperatures, is one of the main reasons for the failure of power semiconductor packaging, including thermal stress, deformation, fatigue aging, and fractures in materials. Therefore, reducing losses of power semiconductor devices, lowering thermal resistance in packaging, and enhancing heat dissipation have always been critical issues in the field of power semiconductors.

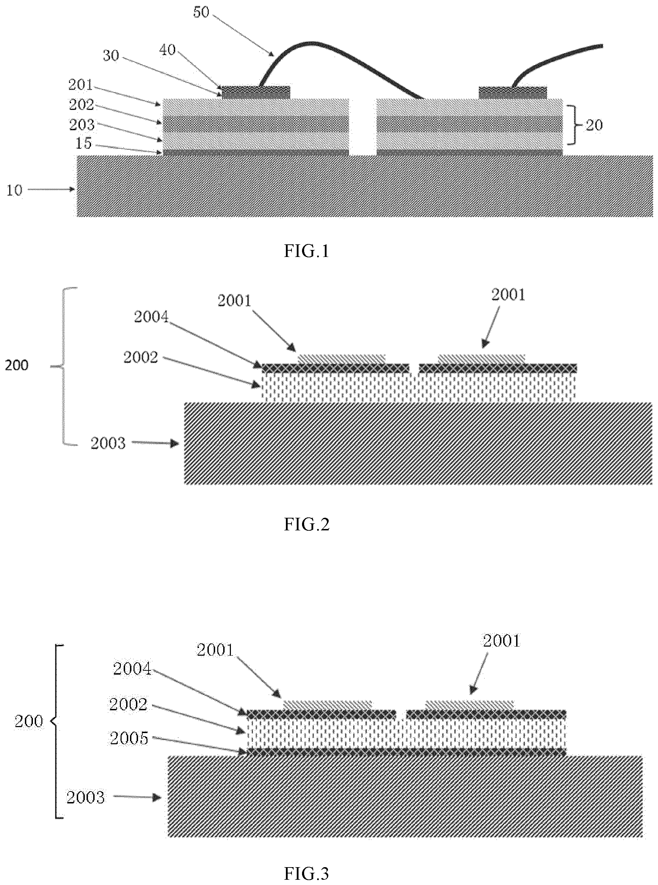

FIG. 1 shows the structure of a typical conventional power semiconductor module and a substrate commonly used in such module. The power module, arranged from bottom to top, comprises a baseplate 10, a substrate 20, a die bonding layer 30, a die 40, and a die top bonding structure 50. The baseplate 10, typically is made from copper, aluminium, or aluminium silicon carbide, serves as both a mechanical support and an enhancer of thermal capacity. Depending on the module type, the baseplate 10 may be affixed to a heat sink using thermal grease, or itself may serve as a heat, for example, having pin fins for improved heat dissipation. The conventional substrate 20, produced using DBC Direct Bonded Copper or AMB Active Metal Brazing technique, is composed of a copper layer 201, a ceramic layer 202 (such as aluminum oxide, aluminum nitride, or silicon nitride), and another copper layer 203. The upper copper layer 201 is commonly patterned to form a functional circuit, while the ceramic layer 202 serves primarily as an electrical insulation layer. The lower copper layer 203 facilitates balancing of mechanical stress, and bonding to the baseplate or heat sink. Soldering or sintering processes are utilized to bond the substrate 20 to the baseplate 10 or heat sink. A semiconductor die 40 is typically soldered or sintered onto the substrate 20 via the die bonding layer 30, and an interconnection on top of the die is established via a die top bonding structure 50 such as wire bonding or the use of copper clips for electrical connection. Finally, the entire structure is packaged with silicone gel or molded plastic.

Two of the main contributors to the thermal resistance in power modules are substrate ceramic layer and bonding layer (also called solder layer), which have relatively low thermal conductivities (Al₂O₃ ~24W/m/K, Si₃N₄ ~90W/m/K, AIN ~180W/m/K and solder -70W/m/K). To improve the relatively low thermal conductivities from soldering, silver sintering technology has also emerged. Compared to soldering, silver sintering has many advantages such as better reliability and higher thermal conductivity at about 200W/m/K for pressure sintering.

However, with the conventional substrate and baseplate, there are still problems such as large thermal resistance and high maximum temperature of the chip.

### SUMMARY OF THE INVENTION

To achieve a lower thermal resistance and reduce the maximum temperature during chip use, the present application provides a novel substrate and a package incorporating the novel substrate.

In the first aspect of the present disclosure, a substrate for power semiconductor packaging is disclosed, characterized in that the substrate comprises: a first metal layer for contacting with a semiconductor device, a second metal layer for contacting with a heat dissipation device, an electrical insulation layer disposed between the first metal layer and the second metal layer, and a first graphene bulk layer disposed between the electrical insulation layer and the first metal layer, a first surface of the first graphene bulk layer is in contact with a first surface of the first metal layer, a second surface of the first graphene bulk layer opposite to the first surface is in contact with a first surface of the electrical insulation layer.

In some embodiments, the substrate further comprises a second graphene bulk layer disposed between the second metal layer and the electrical insulation layer, a first surface of the second graphene bulk layer is in contact with a first surface of the second metal layer.

In some embodiments, the area of the first surface of the second graphene bulk layer is smaller than the area of the first surface of the second metal layer.

In some embodiments, the area of the first surface of the first metal layer is less than or equal to the area of the first surface of the first graphene bulk layer.

In some embodiments, the first surface of the first graphene bulk layer is arranged as patterned graphene.

In some embodiments, the first metal layer and the second metal layer independently comprise any one of copper, gold, nickel, cobalt, aluminum, tungsten, molybdenum, iron, tin, silver, beryllium, or an alloy of any combination thereof.

In some embodiments, the first metal layer and the second metal layer are both metal layers of copper.

In some embodiments, the electrical insulation layer comprises aluminum oxide, aluminum nitride, silicon nitride, boron nitride, or a combination of two or more thereof,
preferably, the electrical insulation layer has a thermal conductivity of 300 W/m/K or more,
preferably, the electrical insulation layer is a boron nitride layer,
preferably, the boron nitride layer has a thermal conductivity of 350-500 W/m/K in horizontal direction and 5-15 W/m/K in vertical direction.

In some embodiments, at least one of the first graphene bulk layer and the second graphene bulk layer is a multilayer graphene,
preferably, the first graphene bulk layer layer and the second graphene bulk layer have a thermal conductivity greater than or equal to 4000 W/m/K in horizontal direction and a thermal conductivity of 5-15 W/m/K in vertical direction,
preferably, the first graphene bulk layer and the second graphene bulk layer have a coefficient of thermal expansion less than or equal to 10 × 10⁻⁶ K⁻¹,
preferably, the first graphene bulk layer and the second graphene bulk layer have an electrical conductivity of 80 × 10⁶-130 × 10⁶ S/m.

In some embodiments, the electrical insulation layer, the first graphene bulk layer, and the second graphene bulk layer are formed on the second metal layer by a molecular beam epitaxy method,
the first metal layer is deposited onto the first graphene bulk layer by a thermal evaporation technology.

In some embodiments, the patterned graphene is formed by a photolithography technology.

In some embodiments, one or both of the electrical insulation layer and the second graphene bulk layer are discontinuous.

In another aspect of the present disclosure, a method for manufacturing the above substrate is disclosed, and the method comprises the following steps:
forming an optional second graphene bulk layer, an electrical insulation layer, and a first graphene bulk layer on a second metal layer,
transferring a patterned circuit layout onto the first graphene bulk layer,
depositing a metal material on the patterned first graphene bulk layer to form a first metal layer at a designated location where the semiconductor device is bonded.

In some embodiments, the optional second graphene bulk layer, the electrical insulation layer, and the first graphene bulk layer are formed on the second metal layer by a molecular beam epitaxy method, and
transferring of the patterned circuit layout is performed by a photolithography technology,
depositing of the metal material is performed by a thermal evaporation technology.

In a further aspect of the present disclosure, a power semiconductor package is disclosed, and the power semiconductor package comprises the above substrate or the substrate manufactured by the above method, a semiconductor device is bonded to the substrate by contacting with a first metal layer, a top bonding structure of the semiconductor device is bonded to the substrate by the first metal layer, terminals are bonded to the first metal layer.

In some embodiments, the semiconductor device is bonded to the first metal layer by solder or sinter, a top bonding structure of the semiconductor device comprises bonding wire, ribbons or clips, or a combination of two or more thereof, the terminals include power terminals and auxiliary signal terminals, and the package material of the power semiconductor package is silicone gel or molding plastic.

The novel substrate of the present invention could reduce the thermal resistance between layers in the substrate, improve the reliability and service life of power devices. Further, by minimizing these thermal barriers, the overall performance and efficiency of the devices can be improved, leading to a reduction in operating temperatures and potential overheating issues. These technological advancements could potentially open up new opportunities for various applications in industries such as electronics, automotive, aerospace, and renewable energy. Further, the development of innovative cooling techniques and materials could contribute to the optimization of thermal management systems, enabling more compact and lightweight designs without compromising performance. Overall, the reduction of thermal resistance has great potential for revolutionizing power device industry and fostering advancements in energy efficiency and sustainability.

### BRIEF DESCRIPTION OF DRAWINGS

FIG. 1 shows a schematic view of the structure of a typical conventional power semiconductor module and a substrate commonly used in such module.
FIG. 2 shows a structural schematic view of the substrate according to the first embodiment of the present invention.
FIG. 3 shows a structural schematic view of the substrate according to the second embodiment of the present invention.
FIG. 4 shows a structural schematic view of the power package incorporating the structure of the substrate shown in FIG. 3.
FIG. 5 shows a structural schematic view of the substrate according to the third embodiment of the present invention.
FIG. 6 shows a structural schematic view of the power package incorporating the structure of the substrate shown in FIG. 5.
FIG. 7 shows a structural schematic view of the power package incorporating the structure of the substrate according to the fourth embodiment of the present invention.
FIG. 8 shows a flowchart of a method for manufacturing the substrate according to the second embodiment of the present invention.
FIG. 9 shows a 3D model of a half-bridge structure composed of IGBT and FRD dies attached to a conventional substrate.
FIG. 10 shows a 3D model of a half-bridge structure composed of IGBT and FRD dies attached to the substrate of the present invention.
FIG. 11 shows an overall temperature distribution view of dies using a conventional substrate.
FIG. 12 shows an overall temperature distribution view of dies using the substrate of the present invention under the same simulation conditions.
FIG. 13 shows a directional heat flux distribution of a conventional substrate and baseplate.
FIG. 14 shows a directional heat flux distribution of the substrate of the present invention.

### DETAIL DESCRIPTION OF EMBODIMENTS

For better understanding by a person skilled in the art to the technical solution of the present invention, the following detailed description of a substrate for power semiconductor packaging and a package containing such substrate provided by the present invention is made with reference to the accompanying drawings as non-limiting examples.

It should also be noted that for the purposes of describing these exemplary embodiments herein, the drawings show general features of the substrate and the package of the exemplary embodiments of the invention. These drawings, however, are not to scale and may not precisely reflect the features of any given embodiment, and should not be interpreted as defining or limiting the numerical ranges or characteristics of the exemplary embodiments within the scope of the present invention.

FIG. 2 shows a structural schematic view of a substrate 200 according to the first embodiment of the present invention. The substrate 200 could be used for power semiconductor packaging. The substrate 200 comprises from top to bottom (i.e., from top part to bottom part) in sequence: a first metal layer 2001, a first graphene bulk layer 2004, an electrical insulation layer 2002, and a second metal layer 2003.

The first metal layer 2001 could be used for contacting with a semiconductor device, for example mainly for bonding dies and facilitating wire bonding or clip bonding, aiming to prevent damage to a graphene bulk layer by directly bonding to a graphene bulk layer circuit layer. The second metal layer 2003 could be used for contacting with a heat dissipation device, mainly as mechanical support and enhancing thermal capacity. A first metal layer could be created at designated locations of a semiconductor device such as dies and bonding points.

The semiconductor device may be, for example, a device such as semiconductor die, IGBT die, FRD die, SiC MOSFET, GaN HEMT, rectifier diode, etc. The heat dissipation device may be, for example, a baseplate or a heat sink, etc. Contact may be, for example, in the form of attachment, bonding or combining by a bonding layer. For example, the semiconductor device such as a die is combined to the first metal layer of the substrate by a bonding layer (solder or sinter), or the first metal layer of the substrate is attached with a die, which is bonded to a wire or clip.

In the first embodiment, the first metal layer 2001 and the second metal layer 2003 independently may comprise any one of copper, gold, nickel, cobalt, aluminum, tungsten, molybdenum, iron, tin, silver, beryllium, or an alloy of any combination thereof. That is, the first metal layer 2001 and the second metal layer 2003 may be formed from any one of copper, gold, nickel, cobalt, aluminum, tungsten, molybdenum, iron, tin, silver, beryllium, respectively, or an alloy of any two or more of these metals. The first metal layer 2001 and the second metal layer 2003 may be formed from the same metal or alloy, or different metals or alloys.

Matching with the prior art, process maturity, and cost advantages, the first metal layer 2001 and the second metal layer 2003 are both preferably metal layers of copper. Further, the first metal layer 2001 and second metal layer 2003 formed from copper can facilitate the growth of graphene bulk layers on their surfaces.

The electrical insulation layer 2002 is disposed between the first metal layer 2001 and the second metal layer 2003.

The electrical insulation layer 2002 is only electrically insulated and may have good thermal conductivity. The electrical insulation layer 2002 may comprise aluminum oxide, aluminum nitride, silicon nitride, boron nitride, or a combination of two or more thereof. That is, the electrical insulation layer is formed from aluminum oxide, aluminum nitride, silicon nitride, boron nitride, or a combination of two or more thereof. The thermal conductivity of the electrical insulation layer (mainly in the horizontal direction) is preferably above 300 W/m/K to ensure the thermal conductivity of the electrical insulation layer and thus the thermal conductivity of the whole substrate.

In a preferred solution, the electrical insulation layer is a boron nitride layer. Boron nitride (BN) offers the following advantages: larger band gap and insulation properties, higher thermal conductivity, lower density, higher corrosion resistance and oxidation resistance, higher mechanical strength, and higher adhesion force with graphene due to similar honeycomb structure.

Preferably, the thermal conductivity of the boron nitride layer in horizontal direction is at least above 300 W/m/K, preferably between 350 and 500 W/m/K, and the thermal conductivity of the boron nitride layer in vertical direction is above 5 W/m/K, preferably 5-15 W/m/K. This can enhance lateral heat dissipation of the boron nitride layer, thereby enhancing overall heat dissipation effect. Horizontal direction is the direction in which the boron nitride layer is spread out, vertical direction is the direction perpendicular to the horizontal direction, that is, perpendicular to the spread out surface of the boron nitride layer.

The first graphene bulk layer 2004 is disposed between the electrical insulation layer 2002 and the first metal layer 2001. The first surface (i.e., upper surface) of the first graphene bulk layer 2004 is in contact with the first surface (i.e., lower surface) of the first metal layer 2001. The second surface (i.e. lower surface) opposite the first surface of the first graphene bulk layer 2004 is in contact with the first surface (i.e. upper surface) of the electrical insulation layer 2002.

The first graphene bulk layer 2004 can be used for both heat dissipation and electrical connection to form a circuit. The first surface of the first graphene bulk layer 2004 can be arranged as a patterned graphene. That is, the first graphene bulk layer 2004 is patterned to form a patterned graphene. The patterned graphene can form a functional circuit and enhance lateral heat dissipation, and then enhance overall heat dissipation. The patterned graphene may be formed by a photolithography technology. For example, the patterned circuit layout is transferred to the first graphene bulk layer 2004 by photolithography to form a patterned graphene on the upper surface of the first graphene bulk layer 2004 to ensure accurate patterning and alignment.

The first graphene bulk layer 2004 may comprise multiple layers of graphene. The first graphene bulk layer 2004 is mainly used for balancing mechanical stress and enhancing lateral heat dissipation, thereby enhancing overall heat dissipation. Graphene itself is a single-layer two-dimensional material. The thickness and number of layers of the first graphene bulk layer 2004 can be adjusted according to the need for heat dissipation and electrical conductivity as well as process capability. The graphene bulk layer exhibits several advantages over copper, including: higher electric conductivity, higher thermal conductivity, lower density, higher corrosion resistance and oxidation resistance and higher mechanical strength.

Preferably, the first graphene bulk layer layer 2004 has a thermal conductivity greater than or equal to 4000 W/m/K in the horizontal direction, and a thermal conductivity of 5-15 W/m/K in the vertical direction. The horizontal and the vertical directions have the same meaning as above. That is, the horizontal direction is the direction in which the first graphene bulk layer is spread out, and the vertical direction is the direction perpendicular to the horizontal direction, that is, perpendicular to the spread out surface of the first graphene bulk layer. The first graphene bulk layer 2004 has excellent thermal conductivity in the horizontal direction.

Preferably, the first graphene bulk layer layer 2004 has a coefficient of thermal expansion less than or equal to 10 × 10⁻⁶ K⁻¹. Preferably, the first graphene bulk layer layer 2004 has a electrical conductivity of 80 × 10⁶-130 × 10⁶ S/m. The first graphene bulk layer 2004 described above is not easily deformed and has excellent electrical conductivity.

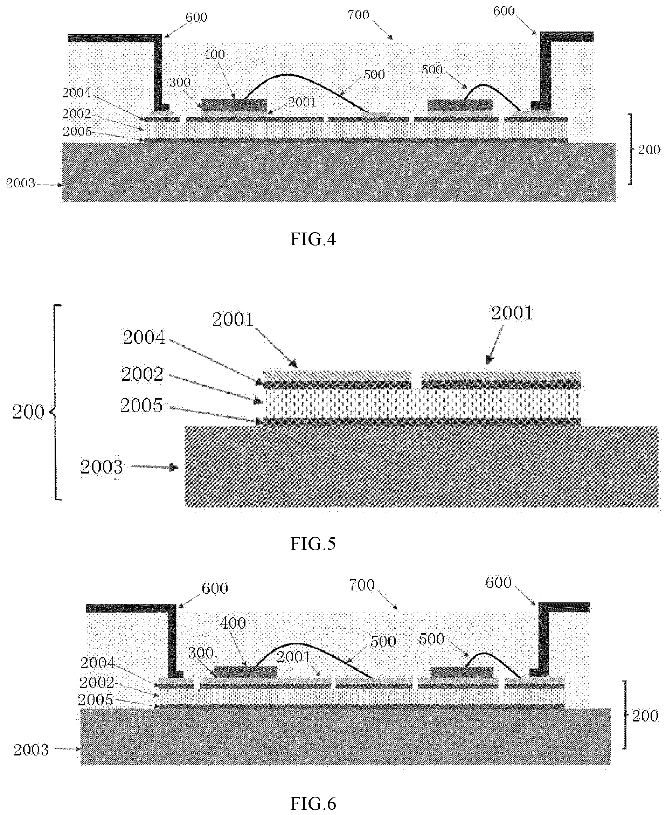

In the first embodiment, as shown in FIG. 2, the area of the first surface of the first metal layer 2001 is less than the area of the first surface of the first graphene bulk layer 2004. Of course, in other embodiments, the area of the first surface of the first metal layer 2001 may be equal to the area of the first surface of the first graphene bulk layer 2004, as shown in the substrate of the third embodiment shown in FIG.5.

The area of the first metal layer 2001 is arranged to be less than the area of the first surface of the first graphene bulk layer 2004 mainly because the first metal layer 2001 in this embodiment serves only as chip soldering and wire striking, soldering terminals, and the like, and the first metal layer does not need to be connected together to form a circuit, which is provided by the graphene layer. The benefit of such arrangement is to be able to reduce the unfavorable influence of the metal layer, such as a copper layer, on the thermal conductivity of graphene. In the third embodiment in FIG. 5, wherein the area of the first metal layer 2001 is equal to the area of the first graphene bulk layer 2004, the first metal layer 2001 forms a circuit like the first graphene bulk layer 2004, such that current carrying capability could be enhanced.

In the first embodiment of FIG. 2, a molecular beam epitaxy method could be used to directly form the electrical insulation layer 2002 and the first graphene bulk layer 2004 on the second metal layer 2003. Using molecular beam epitaxy (MBE) method to grow the electrical insulation layer 2002 and the first graphene bulk layer 2004 on the substrate eliminates the need for a solder layer, thereby ensuring higher reliability of the manufactured substrate.

The first metal layer 2001 may be deposited onto the first graphene bulk layer 2004 by a thermal evaporation technology to produce the first metal layer at a designated location of a semiconductor device such as dies and bonding points.

The method for manufacturing the substrate in the first embodiment may comprise the following steps:
- sequentially forming the electrical insulation layer 2002 and the first graphene bulk layer 2004 on the second metal layer 2003 by a molecular beam epitaxy (MBE) method;
- transferring the patterned circuit layout onto the the first graphene bulk layer 2004 by a photolithography technology,
- depositing metal material on the patterned first graphene bulk layer 2004 by a thermal evaporation technology to form the first metal layer 2001 at a designated location where the semiconductor device is bonded.

FIG. 3 shows a structural schematic view of the substrate 200 according to the second embodiment of the present invention. The difference between the substrate of the second embodiment and the substrate of the first embodiment is only that the substrate 200 of the second embodiment further comprises a second graphene bulk layer 2005. The function of the second graphene bulk layer 2005 may be the same as that of the first graphene bulk layer 2004, enhancing lateral heat dissipation, thereby enhancing overall heat dissipation, and also used for balancing mechanical stress brought by the first graphene bulk layer. The second graphene bulk layer 2005 is disposed between the second metal layer 2003 and the electrical insulation layer 2002, The first surface (i.e., lower surface) of the second graphene bulk layer 2005 is in contact with the first surface (i.e., upper surface) of the second metal layer 2003. The process of arranging the second graphene bulk layer 2005 on the metal layer is more mature relative to direct growth of boron nitride on the metal layer, such as copper layer, making manufacturing easier during this period. Similarities between the substrate of the second embodiment and the substrate of the first embodiment will not be repeated.

As shown in FIG. 3, the area of the first surface (i.e., lower surface) of the second graphene bulk layer 2005 is smaller than the area of the first surface (i.e., upper surface) of the second metal layer 2003. In this way, the second metal layer 2003 can reserve space to package a shell or mold, and can also reserve bolt holes for installation.

Further, the area of the lower surface of the first metal layer 2001 is much smaller than the area of the upper surface of the first graphene bulk layer 2004, and the first metal layer 2001 is only used for die attachment and wirebonding or clip bonding, The first graphene bulk layer 2004 may be used for both heat dissipation and electrical connection to form a circuit.

Similar to the first graphene bulk layer 2004, the second graphene bulk layer 2005 may also comprise multiple layers of graphene. The second graphene bulk layer 2005 may have the same characteristics as the first graphene bulk layer above, and will not be repeated here. At least one of the first graphene bulk layer layer 2004 and the second graphene bulk layer 2005 is multilayer graphene.

A molecular beam epitaxy method could be used to form the second graphene bulk layer 2005 on the second metal layer 2003. Because the graphene is directly grown on copper, the bonding between metal atoms such as copper atoms and carbon atoms occurs at atomic level, making ideal bonding.

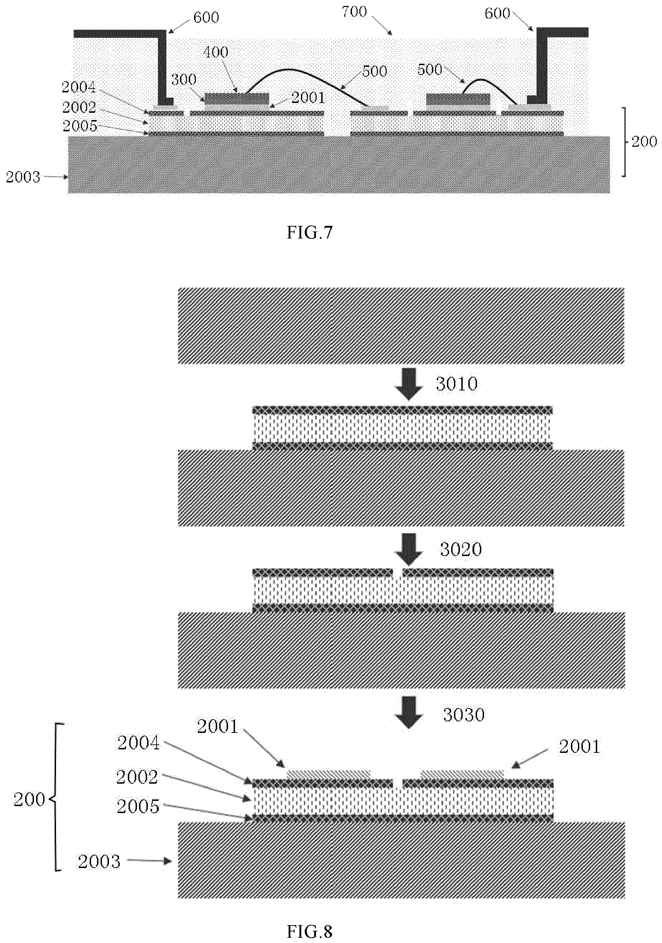

As shown in FIG. 8, the method for manufacturing the substrate in the second embodiment may comprise the following steps:
- sequentially forming the second graphene bulk layer 2005, the electrical insulation layer 2002 and the first graphene bulk layer 2004 on the second metal layer 2003 by a molecular beam epitaxy (MBE) method 3010;
- transferring the patterned circuit layout onto the the first graphene bulk layer 2004 by a photolithography technology 3020;
- depositing metal material on the patterned first graphene bulk layer 2004 by a thermal evaporation technology 3030 to form the first metal layer 2001 at a desginated location where the semiconductor device is bonded.

FIG. 4 shows a structural schematic view of the power package incorporating the structure of the substrate shown in FIG. 3, wherein semiconductor die 400 is bonded to the substrate 200 through the first metal layer 2001, and the bonding layer 300 may be a solder or a sinter. Die top bonding structure 500 may be bonding wire, ribbons or clips, and bonding with substrate 200 is also performed through the first metal layer 2001. Terminals 600 including power terminals and auxiliary signal terminals are bonded to the first metal layer 600. This structure is packaged with material 700 such as silicone gel or molding material.

The power package utilizing the novel substrate offers the benefits associated with the aforementioned novel substrate, such as reducing mechanical stress and enhancing overall heat dissipation effect. Further, compared with copper, the graphene bulk has much lower coefficient of thermal expansion (CTE), and the thermal stress on the dies can be lower. Further, due to the exceptionally high in-plane thermal conductivity of graphene and the insulation layer such as BN layer, heat could be rapidly diffused in the horizontal direction, thereby increasing the overall heat dissipation area. According to the formula Rth=d/kA, where Rth represents thermal resistance, d is thickness, k is thermal conductivity, and A is area, it can be observed that an increase in the heat dissipation area further reduces thermal resistance, thereby enhancing heat dissipation capabilities of the semiconductor dies.

Comparing to conventional power packages utilizing ceramic insulators, the package structure of the present invention due to graphene and insulating layer such as boron nitride (BN) offers a substantial enhancement in heat dissipation capability for the power semiconductor chips.

FIG. 5 shows a structural schematic view of the substrate 200 according to the third embodiment of the present invention. The difference between the substrate of the third embodiment and the substrate of the second embodiment is only that the lower surface area of the first metal layer 2001 in the substrate 200 of the third embodiment is substantially the same as the upper surface area of the first graphene bulk layer 2004, and the first metal layer 2001 is used for die attachment and wirebonding or clip bonding, as well as electrical connection to form a circuit, thereby increasing current carrying capacity. The graphene bulk layer 5 still serves as both heat dissipation and electrical connection to form a circuit.

The method for manufacturing the substrate in this embodiment is the same as that in the second embodiment.

FIG. 6 shows a structural schematic view of the power package incorporating the structure of the substrate shown in FIG. 5. Similarly, semiconductor die 400 is bonded to the substrate 200 through the first metal layer 2001, and the bonding layer 300 may be a solder or a sinter. Die top bonding structure 500 may be bonding wire, ribbons or clips, and bonding with the substrate 200 is also performed on the first metal layer 2001. Terminals 600 including power terminals and auxiliary signal terminals 600 are bonded to the first metal layer 2001. This structure is packaged with material 700 such as silicone gel or molding material.

This power package using the novel substrate provides similar benefits to the power package of the second embodiment.

FIG. 7 shows a structural schematic view of the power package incorporating the structure of the substrate of the fourth embodiment.

The differences between the substrate 200 of the fourth embodiment and the substrate of the third embodiment are that the electrical insulation layer 2002 and the second graphene bulk layer 2005 are both discontinuous, e.g. disconnected, which typically allows the substrate to be applied to large power packages to reduce mechanical stress and enhance reliability.

The differences between the method for manufacturing substrate of this embodiment and the above embodiments are: after growing the second graphene bulk layer 2005, further etching steps are required to separate the whole graphene bulk layer.

Physical properties of different materials used in the embodiments of the present invention and the materials used in the prior art are listed in Table 1 below.

**Table 1 Physical properties of different materials used in the embodiments of the present invention and the materials used in the prior art**

| Material | Thermal conductivity [W/m/K] | | CTE [10⁻⁶ K⁻¹] | | Electrical Conductivity [10⁶ S/m] | | Dielectric Strength [kV/mm] | | Flexure strength [MPa] |
|---|---|---|---|---|---|---|---|---|---|
| Graphene bulk layer | 5000(horizontal) | | <9 | | 100 | | - | | - |
| | 10 (vertical) | | | | | | | | |
| Copper | 385 | | 16.5 | | 60 | | - | | - |
| BN | 400(horizontal) | | 4.8 | | - | | 374 | | 70000 |
| | 10 (vertical) | | | | | | | | |
| Al₂O₃ | 30 | | 7.5 | | - | | 15 | | 350 |
| AlN | 180 | | 4.6 | | - | | 17 | | 350 |
| Si₃N₄ | 90 | | 3.4 | | - | | 18 | | 700 |

Compared to the conventional substrate and baseplate in FIG. 1, the novel substrate of the present invention exhibits much lower thermal resistance, higher mechanical strength, and enhanced corrosion resistance. Further, the baseplate in the present invention is not an electrically conductive part of the circuit, and does not carry electrical current. The substrate and power packaging of the present invention can be applied to power packages for industrial, electric vehicle, solar, wind inverters, on-board chargers or home appliances.

### Performance test

The following is a comparative test for the application performance of the substrate prepared by the present invention and conventional substrate.

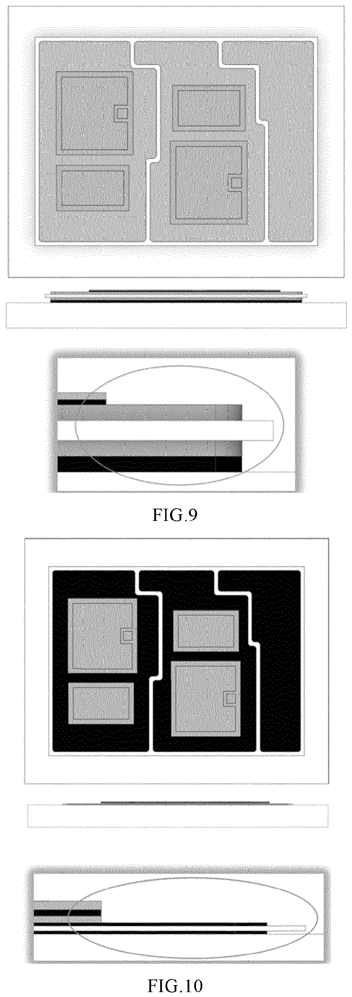

FIG. 9 shows a 3D model of a half-bridge structure composed of IGBT and FRD dies attached to a conventional substrate. FIG. 10 shows a 3D model of a half-bridge structure composed of IGBT and FRD dies attached to the substrate of the present invention. An overall temperature distribution of dies using a conventional substrate and the substrate of the present invention was tested under the same simulation conditions.

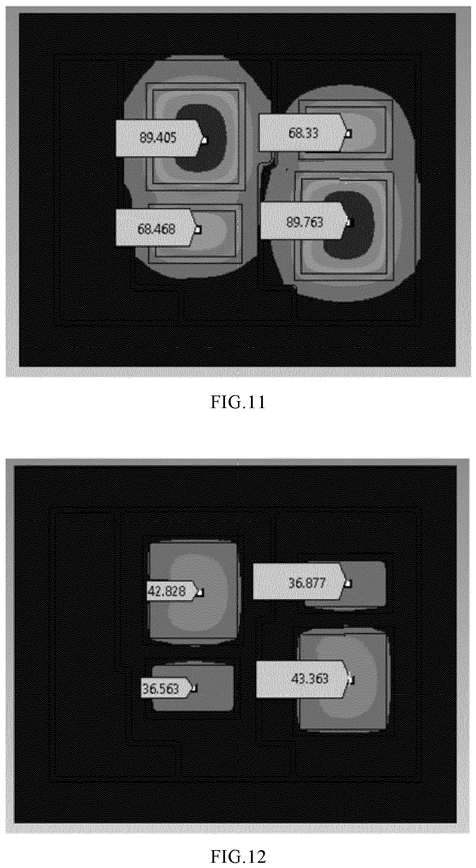

FIG. 11 shows an overall temperature distribution view of dies using a conventional substrate. FIG. 12 shows an overall temperature distribution view of dies using the substrate of the present invention under the same simulation conditions. Table 2 below lists power loss and thermal resistance comparison between the substrate of the present invention and conventional substrate & baseplate. From these figures and Table 2, it can be seen that when using conventional substrate and baseplate, the highest temperature of the chip at different nodes reaches 89.763°C, with a junction-to-case thermal resistance Rthjc of IGBT dies of 0.26K/W, and a junction-to-case thermal resistance Rthjc of FRD dies of 0.46K/W. By contrast, the chip of the novel substrate of the present invention at different nodes exhibits a significantly lower temperature of only 43.363°C, with a junction-to-case thermal resistance of IGBT dies of 0.08K/W, and a junction-to-case thermal resistance Rthjc of FRD dies of 0.15K/W. It can be seen that using the substrate of the present invention could significantly reduce the maximum temperature of the chip by over 50%, and the junction-to-case thermal resistance is significantly reduced even more. Comparing with conventional substrate structure, the thermal resistance of the substrate of the present invention could be reduced by about 69%.

**Table 2 Power loss and thermal resistance comparison between the substrate of the present invention and a conventional substrate & baseplate**

| | | **Power loss [W]** | **Rthjc [K/W]** |
|---|---|---|---|
| Conventional substrate & baseplate | IGBT | 260 | 0.26 |
| | FRD | 100 | 0.46 |
| Substrate of the present invention | IGBT | 260 | 0.08 |
| | FRD | 100 | 0.15 |

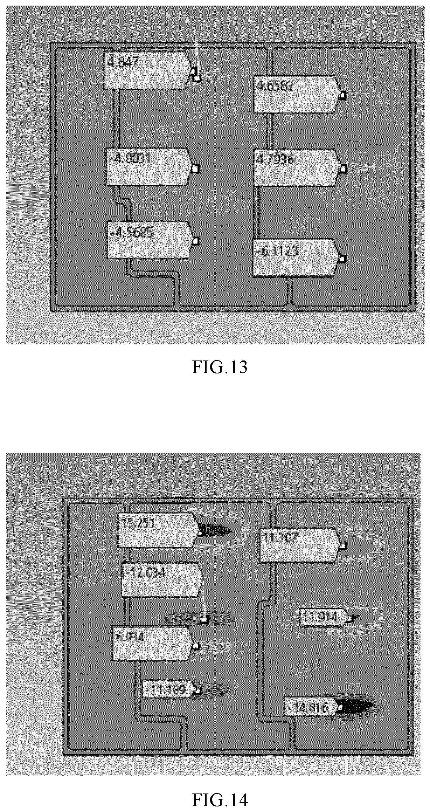

FIG. 13 shows a directional heat flux distribution of the conventional substrate & baseplate, with a maximum flux of 4.847W/mm2 at different nodes. FIG. 14 shows a directional heat flux distribution of the substrate of the present invention under the same experimental conditions, wherein the maximum flux at different nodes is 15.251W/mm², which is much greater than the directional heat flux distribution of the conventional substrate & baseplate, and the overall heat flux distribution is also much higher than the directional heat flux distribution of the conventional substrate & baseplate.

FIGS. 13 and 14 reveal one of the main reasons for the enhanced heat dissipation of the present invention, i.e., the invention enhances heat transfer in horizontal direction and enlarges a heat dissipation area, thereby reducing thermal resistance, lowering junction temperature, and enhancing heat dissipation.

It should be understood that the arrangement of the components shown in the accompanying drawings is for illustrative purposes and that other arrangements are also possible.

Further, the embodiments and examples described herein are for illustrative purposes only and various modifications or variations thereof can be made by a person skilled in the art, which are also included within the spirit and scope of the present application and the accompanying claims.

## Claims

1. A substrate for a power semiconductor packaging, **characterized in that** the substrate comprises:
a first metal layer for contacting with a semiconductor device,
a second metal layer for contacting with a heat dissipation device,
an electrical insulation layer disposed between the first metal layer and the second metal layer, and
a first graphene bulk layer disposed between the electrical insulation layer and the first metal layer, a first surface of the first graphene bulk layer is in contact with a first surface of the first metal layer, a second surface of the first graphene bulk layer opposite to the first surface is in contact with a first surface of the electrical insulation layer.

2. The substrate according to claim 1, **characterized in that** the substrate further comprises a second graphene bulk layer disposed between the second metal layer and the electrical insulation layer, a first surface of the second graphene bulk layer is in contact with a first surface of the second metal layer.

3. The substrate according to claim 2, **characterized in that** the area of the first surface of the second graphene bulk layer is smaller than the area of the first surface of the second metal layer.

4. The substrate according to any one of claims 1 to 3, **characterized in that** the area of the first surface of the first metal layer is less than or equal to the area of the first surface of the first graphene bulk layer.

5. The substrate according to any one of claims 1 to 4, **characterized in that** the first surface of the first graphene bulk layer is arranged as patterned graphene.

6. The substrate according to any one of claims 1 to 5, **characterized in that** the first metal layer and the second metal layer independently comprise any one of copper, gold, nickel, cobalt, aluminum, tungsten, molybdenum, iron, tin, silver, beryllium, or an alloy of any combination thereof,
preferably, the first metal layer and the second metal layer are both metal layers of copper.

7. The substrate according to any one of claims 1 to 6, **characterized in that** the electrical insulation layer comprises aluminum oxide, aluminum nitride, silicon nitride, boron nitride, or a combination of two or more thereof,
preferably, the electrical insulation layer has a thermal conductivity of 300 W/m/K or more,
preferably, the electrical insulation layer is a boron nitride layer,
preferably, the boron nitride layer has a thermal conductivity of 350-500 W/m/K in horizontal direction and 5-15 W/m/K in vertical direction.

8. The substrate according to any one of claims 2 to 7, **characterized in that** at least one of the first graphene bulk layer and the second graphene bulk layer is a multilayer graphene,
preferably, the first graphene bulk layer and the second graphene bulk layer have a thermal conductivity greater than or equal to 4000 W/m/K in horizontal direction and a thermal conductivity of 5-15 W/m/K in vertical direction,
preferably, the first graphene bulk layer and the second graphene bulk layer have a coefficient of thermal expansion less than or equal to 10 × 10⁻⁶ K⁻¹,
preferably, the first graphene bulk layer and the second graphene bulk layer have an electrical conductivity of 80 × 10⁶-130 × 10⁶ S/m.

9. The substrate according to any one of claims 1 to 8, **characterized in that** the electrical insulation layer, the first graphene bulk layer, and the second graphene bulk layer are formed on the second metal layer by a molecular beam epitaxy method,
the first metal layer is deposited onto the first graphene bulk layer by a thermal evaporation technology.

10. The substrate according to any one of claims 5 to 9, **characterized in that** the patterned graphene is formed by a photolithography technology.

11. The substrate according to any one of claims 5 to 10, **characterized in that** one or both of the electrical insulation layer and the second graphene bulk layer are discontinuous.

12. A method for manufacturing the substrate according to any one of claims 1 to 11, **characterized in that** the method comprises the following steps:
forming an optional second graphene bulk layer, an electrical insulation layer, and a first graphene bulk layer on a second metal layer,
transferring a patterned circuit layout onto the first graphene bulk layer,
depositing a metal material on patterned first graphene bulk layer to form a first metal layer at a designated location where the semiconductor device is bonded.

13. The method according to claim 12, **characterized in that**
the optional second graphene bulk layer, the electrical insulation layer, and the first graphene bulk layer are formed on the second metal layer by a molecular beam epitaxy method, and
transferring of the patterned circuit layout is performed by a photolithography technology,
depositing of the metal material is performed by a thermal evaporation technology.

14. A power semiconductor package, **characterized in that** the power semiconductor package comprises the substrate according to any one of claims 1 to 11 or the substrate manufactured according to claim 12 or 13, a semiconductor device is bonded to the substrate by contacting with a first metal layer, a top bonding structure of the semiconductor device is bonded to the substrate by the first metal layer, terminals are bonded to the first metal layer.

15. The package according to claim 14, **characterized in that** the semiconductor device is bonded to the first metal layer by solder or sinter,
a top bonding structure of the semiconductor device comprises bonding wire, ribbons or clips, or a combination of two or more thereof,
the terminals comprise power terminals and auxiliary signal terminals, and
the package material of the power semiconductor package is silicone gel or molding plastic.
